# EUROPEAN PATENT APPLICATION

(11) **EP 1 361 298 A1**
(43) Date of publication of application: **12.11.2003**
(21) Application number: 02711482.6
(22) Date of filing: 12.02.2002
(51) Int. Cl.: C30B 25/18, H01L 21/205

(54) **SEMICONDUCTOR CRYSTAL GROWING METHOD AND SEMICONDUCTOR LIGHT-EMITTING DEVICE**

(30) Priority: 14.02.2001 JP 2001036568
(71) Applicant: Toyoda Gosei Co., Ltd., Nishikasugai-gun, Aichi 452-8564 (JP)
(72) Inventor: NAGAI, Seiji, c/o TOYODA GOSEI CO., LTD, Aichi-gun, Aichi 452-8564 (JP); TOMITA, Kazuyoshi, c/o K.K. TOYOTA CHUO KENKYUSHO, Aichi-gun, Aichi 480-1192 (JP); IROKAWA, Yoshihiro, c/o K.K. TOYOTA CHUO KENKYUSHO, Aichi-gun, Aichi 480-1192 (JP); KACHI, Tetsu, c/o K.K. TOYOTA CHUO KENKYUSHO, Aichi-gun, Aichi 480-1192 (JP)
(74) Representative: Leson, Thomas Johannes Alois, Dipl.-Ing.
(86) International application number: JP0201168
(87) International publication number: WO02064865

(57) **Abstract**

Hydrogen ion (H⁺) is injected into a Si (111) substrate (base substrate) 10 at the approximately ambient temperature at a doping rate of 1 x 10¹⁶/cm² and at an accelerating voltage of 10keV. As a result, an ion injection layer whose ion concentration is locally high is formed at the depth h ≒ 100nm from the surface (ion injection plane) by injecting ion. About 300nm of AlGaN buffer layer 20 is formed on the ion injection front of the Si substrate 10, and about 200µm of gallium nitride (GaN) layer 30 is deposited thereon as an objective semiconductor crystal. In this crystal growing process, the Si substrate 10 is ruptured at the ion injection layer and is finally separated into about 100nm of thin film part 11 and a main part of the Si substrate 10. According to this method for producing a semiconductor crystal, a single crystalline gallium nitride (GaN) which has more excellent crystallinity and less cracks than a conventional one can be obtained.

## Description

### Technical Field

The present invention relates to a crystal growth method of semiconductor by growing a semiconductor material on a base substrate in order to obtain a semiconductor crystal. The semiconductor material is different from the material of the base substrate.

### Background Art

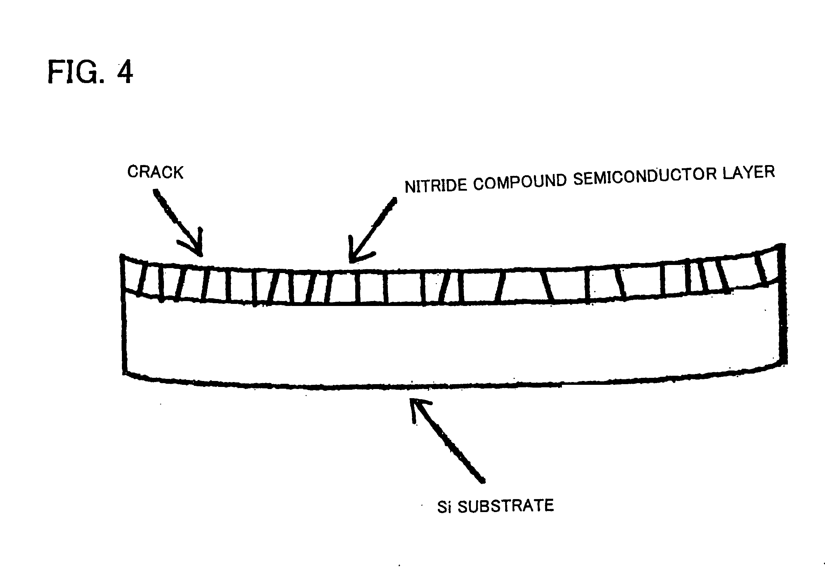

As shown in FIG. 4 and as is widely known, when a gallium nitride (GaN) formed by crystal growth on a silicon substrate is cooled to ambient temperature, a number of dislocations and cracks are generated in the grown GaN layer.

When a number of dislocations and cracks are generated in the grown layer, a number of lattice defects, dislocations, deformation, cracks, etc., are generated in a device fabricated thereon from the semiconductor layer, thereby deteriorating device characteristics.

When the silicon (Si) substrate except for the grown layer is removed so as to obtain a free-standing substrate, the substrate cannot have larger area (1cm² and bigger) because of dislocations and cracks described above.

In order to obtain a semiconductor crystal having excellent quality by employing, for example, such a hetero epitaxial growth, the following methods had been used as conventional methods.

### (Prior Art 1)

A low-temperature deposition buffer layer is formed on a substrate. In this method, a group III nitride compound semiconductor such as AlGaN, AlN, GaN and AlGaInN is deposited at a low temperature to be a buffer layer which relaxes inner stress owing to difference of lattice constants.

### (Prior Art 2)

In this method, a material whose lattice constant is comparatively close to that of an objective grown semiconductor crystal is chosen to form a crystal growth substrate. When the objective semiconductor crystal is, for example, a single crystalline gallium nitride (GaN), silicon carbide (SiC) may be used to form the crystal growth substrate.

### Disclosure of the Invention

Stress generated between an objective semiconductor crystal and a substrate, however, cannot be relaxed sufficiently even by forming the buffer layer. In short, the buffer layer described above can relax only a part of the stress. So when gallium nitride (GaN) is formed on a sapphire substrate by employing crystal growth, for example, considerable number of defects may be generated in the objective semiconductor crystal (gallium nitride layer) even a GaN low-temperature deposition buffer layer is used.

When a substrate whose lattice constant is close to that of an objective semiconductor crystal is used, stress owing to difference of lattice constants may be relaxed but there remains difficulty in relaxing stress owing to the difference of thermal expansion coefficients. As a result, considerable numbers of defects may be generated in an objective semiconductor crystal (gallium nitride layer) in a process of lowering the temperature after crystal growth.

Cracks are also generated and that makes it difficult to obtain a free-standing semiconductor crystal having a large area.

The present invention has been accomplished in order to overcome the aforementioned drawbacks. Thus, an object of the present invention is to produce a high quality semiconductor crystal having low dislocation density and no cracks and which have excellent characteristics.

In order to overcome the above-described drawbacks, the followings may be useful.

That is, the first aspect of the present invention provides a method for crystal growth of a semiconductor which is grown on a base substrate and is made of different semiconductor material from that of the base substrate, comprising a step of injecting ion into the base substrate from the crystal growth front before carrying out crystal growing process of the semiconductor.

The second aspect of the present invention is a method according to the first aspect, wherein a portion or the entire portion of the base substrate is ruptured by heating or cooling the base substrate after the crystal growth process.

The third aspect of the present invention is a method according to the first or second aspect, wherein ion is injected to depth of 20µm or less from the crystal growth front.

The fourth aspect of the present invention is a method according to any one of the first to third aspects, wherein hydrogen ion (H⁺) or helium ion (He⁺) is used as the ion injected to the base substrate.

The fifth aspect of the present invention is a method according to any one of the first to fourth aspects, wherein injection amount of ion injected from the crystal growth front per unit area is 1 x 10¹⁵[/cm²] to 1 x 10²⁰ [/cm²].

The sixth aspect of the present invention is a method according to any one of the first to fifth aspects, wherein the base substrate is made of at least one selected from the group consisting of silicon (Si), sapphire (Al₂O₃), silicon carbide (SiC), gallium arsenide (GaAs), zinc oxide (ZnO), neodymium gallium oxide (NdGaO₃), lithium gallium oxide (LiGaO₂) and magnesium aluminum oxide (MgAl₂O₄).

The seventh aspect of the present invention is a method according to any one of the first to sixth aspects, wherein a group III nitride compound semiconductor is applied as the semiconductor material.

As used herein, the term "group III nitride compound semiconductor" generally refers to a binary, ternary, or quaternary semiconductor having arbitrary compound crystal proportions and represented by AlₓGa_{y}In_{(1-x-y)}N (0 ≤ x ≤ 1; 0 ≤ y ≤ 1; 0 ≤ x + y ≤ 1). The "group III nitride compound semiconductor" of the present invention also encompasses such species containing a small amount of p-type or n-type dopant which scarcely effects the composition ratios x and y.

Accordingly, the "group III nitride compound semiconductor" of the present invention is, for example, a binary or ternary "group III nitride compound semiconductor," it encompasses, needless to mention, AlN, GaN and InN, and AlGaN, AlInN and GaInN having arbitrary compound crystal proportions. And it also encompasses such species containing a small amount of p-type or n-type dopant which scarcely affects the composition ratios of each semiconductor.

In the present specification, the "group III nitride compound semiconductor" also encompasses semiconductors in which the aforementioned Group III elements (Al, Ga, In) are partially substituted by boron (B), thallium (Tl), etc. or in which nitrogen (N) atoms are partially substituted by phosphorus (P), arsenic (As), antimony (Sb), bismuth (Bi), etc.

Examples of the p-type dopant which can be added include at least one of magnesium (Mg) and calcium (Ca).

Examples of the n-type dopant which can be added include at least one of silicon (Si), sulfur (S), selenium (Se), tellurium (Te), and germanium (Ge).

These dopants may be used in combination of two or more species, and a p-type dopant and an n-type dopant may be added simultaneously.

The eighth'aspect of the present invention is a method according to any one of the first to seventh aspects, wherein the base substrate is treated by heat treatment after ion injecting process and before crystal growing process.

The ninth aspect of the present invention is a semiconductor light-emitting device comprising at least a semiconductor crystal which is produced by a method according to any one of the first to eighth aspects as a crystal growth substrate.

The tenth aspect of the present invention is to produce a semiconductor light-emitting device by employing crystal growth in which a semiconductor crystal produced by a method according to any one of the first to eighth aspects is at least used as a crystal growth substrate.

The aforementioned problems may be solved by employing these aspects of the present invention.

By adjusting the accelerating voltage level of ion to be constant at the entire surface of the base substrate to which ion is injected and keeping the accelerating voltage constant for a certain time, the depth from the surface of the base substrate to which ions are injected (ion injection front) may be kept approximately constant. In short, by injecting ion like that, the depth of injecting ion at which ion concentration becomes maximum (depth h at the maximum ion concentration) is approximately in proportion to accelerating voltage and the depth becomes approximately uniform at the entire surface of the ion injection front. The layer which is arranged near depth h at the maximum ion concentration and whose ion concentration is locally high is called "ion injection layer" hereinafter.

The ion injected into the base substrate changes its physical condition by such as expansion and evaporation in the heating process. And such change in physical condition is remarkably larger compared with other change in condition caused by such as thermal expansion of the base substrate.

When the base substrate into which ions are injected is used as a crystal growth substrate, the base substrate is partially ruptured at the ion injection layer owing to crystal growth temperature and heating or cooling process. The ruptured base substrate is finally separated into a thin film part which is at the ion injection front side of the base substrate and a main part of the base substrate.

Because the thin film part is very thin and partially separated from the substrate, stress owing to difference of lattice constants hardly affect the objective semiconductor layer grown on the thin film. That enables the objective semiconductor crystal to have more excellent crystallinity than that of the conventional semiconductor crystal.

Further, in the cooling process after crystal growing process, because the substrate (thin film part) is very thin and partially separated from the base substrate, stress owing to difference of thermal expansion coefficients of the objective semiconductor crystal formed on the thin film part and the base substrate separates the base substrate at the ion injection layer into the thin film part which is at the ion injection front side and the main part of the base substrate in comparatively earlier stage of the cooling process. Because of that, after the separation process stress owing to difference of thermal expansion coefficients hardly affect the thin film part and the semiconductor crystal deposited thereon.

By employing those procedures, the present invention can supply a high quality semiconductor crystal which has no cracks and fewer dislocations.

Here depth (depth h at the maximum ion concentration) of injecting ion is preferably smaller than thickness of the objective semiconductor crystal. Generally, an absolute standard of depth h is preferably 20µm or less. When depth h is too large, stress mentioned above cannot be relaxed sufficiently.

Well-known materials for crystal growth substrate are used to form the base substrate. By using materials such as silicon (Si), sapphire (Al₂O₃), silicon carbide (SiC), gallium arsenide (GaAs), zinc oxide (ZnO), neodymium gallium oxide (NdGaO₂), lithium gallium oxide (LiGaO₂) or magnesium aluminum oxide (MgAl₂O₄) for a crystal growth substrate (the base substrate described above) in crystal growing process, actions and effects of the present invention can be obtained.

Through employment of the aforementioned aspects of the present invention, the aforementioned drawbacks can be overcome effectively and rationally.

### Brief Description of the Drawings

FIGS. 1A-1B are schematic cross-sectional views of a semiconductor according to the present embodiment.
FIG. 2 is a graph showing the relationship between number (concentration) of injected ion and depth of the injected ion according to the present invention.
FIG. 3 is a graph showing the relationship between depth (depth h at the maximum ion concentration) of ion injection and injection energy of ion.
FIG. 4 is a schematic cross-sectional view showing crystal growth condition of a conventional semiconductor crystal.

### Best Mode for Carrying Out the Invention

Embodiments of the present invention will next be described with reference to the drawings. Characteristic features of the present invention have been described above, and the present invention is not limited to the below-described specific embodiments.

### (1) Producing an ion injection substrate (base substrate)

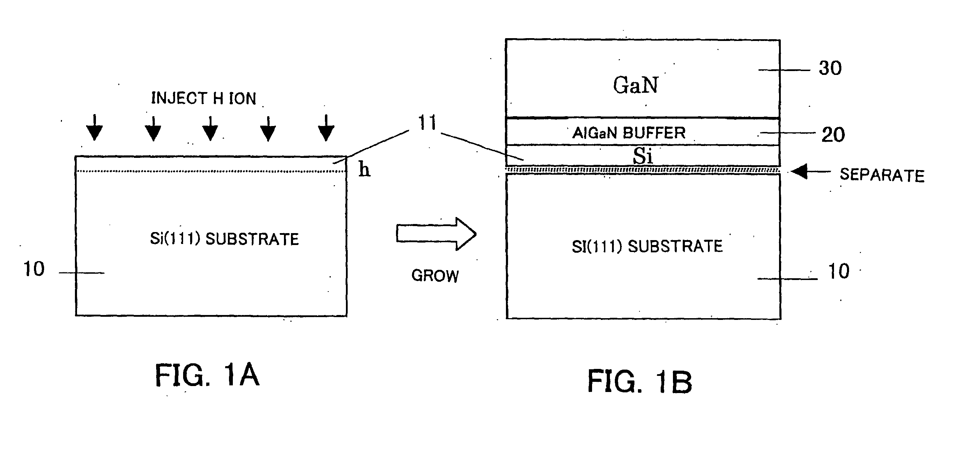

Hydrogen ion (H⁺) is injected into a Si (111) substrate (base substrate) at a doping rate of 1 x 10¹⁶/cm² and an accelerating voltage of 10keV at an approximately ambient temperature (FIG. 1A).

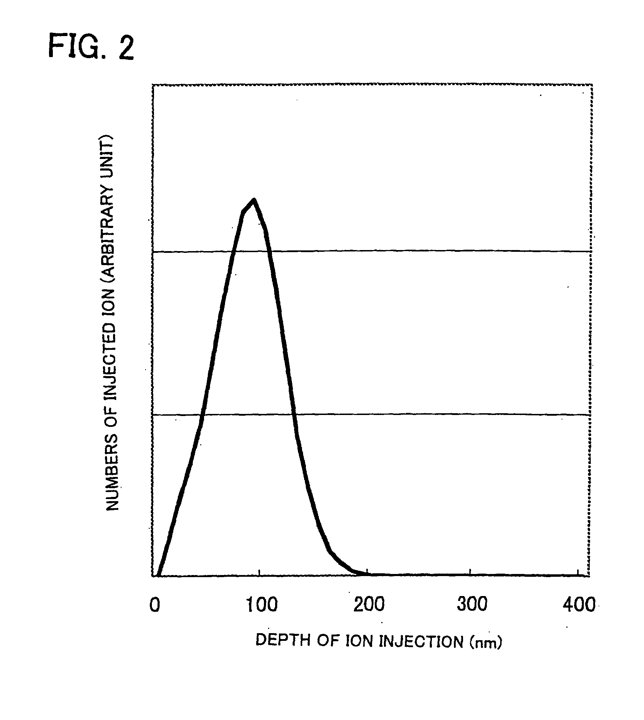

FIG. 2 is a graph illustrating the relationship between the number (concentration) of injected ion and depth of injecting ion at this time. By injecting ion, as shown in FIG. 2, an ion injection layer whose ion concentration is locally high is formed at the depth around 100nm from the surface (ion injection plane).

### (2) GaN/Si crystal growth

Then the following crystal growth is carried out through metal-organic vapor phase epitaxy (hereinafter called "MOVPE").

About 300nm of AlGaN buffer layer 20 is formed on the ion injection plane of the Si substrate (base substrate) 10 at the temperature of 1100°C, and about 200µm in thickness of gallium nitride (GaN) layer 30, or an objective semiconductor crystal, is grown thereon at the temperature of 1050°C (FIG. 1B). In this heating up process before crystal growth, the Si substrate 10 is ruptured at the ion injection layer which is placed at the depth h of around 100nm from the surface (ion injection plane) and is finally separated into about 100nm in thickness of thin film 11 and a main portion of the Si substrate 10 in the cooling process after crystal growth.

By employing this method for producing a semiconductor crystal, a single crystalline gallium nitride (GaN) which has more excellent crystallinity than that of a conventional one and has no crack can be obtained.

Accordingly, by employing such an excellent single crystalline to a portion of a semiconductor light-emitting device, e.g., to a crystal growth substrate, it becomes possible or easier to produce a semiconductor product, e.g, a semiconductor light-emitting device and a semiconductor light-receiving device, which has a high luminous efficiency and whose driving voltage is more decreased compared with a conventional device.

Also, by employing such an excellent single crystalline, it becomes possible or easier to produce not only a luminous device but also semiconductor electron device such as a semiconductor power device having a high voltage-withstand-characteristic and a semiconductor high-frequency device which works to a high frequency.

Then ranges for a modified embodiment of the present invention independent from the above embodiment are explained hereinafter.

Each range for modified embodiment can be also applied to the above described embodiment.

For example, metal-organic vapor phase epitaxy (MOVPE) is employed in the above embodiment. Alternatively, crystal growth of the present invention may be carried out through halide vapor phase growth (HVPE).

Also helium ion (He⁺) in place of hydrogen ion (H⁺) may be used to obtain action and effect of the above embodiment.

Doping amount of hydrogen ion may be, although it depends on a material used to form the base layer, about 1 x 10¹⁵[/cm²] to 1 x 10²⁰[/cm²] to obtain approximately the same action and effect as those of the above embodiment. More preferably, doping amount of hydrogen ion may be about 3 x 10¹⁵[/cm²] to 1 x 10¹⁷[/cm²], and further preferably, it may be about 8 x 10¹⁵[/cm²] to 2 x 10¹⁶[/cm²]. When a range of doping amount of hydrogen ion is proper, the thin film part and the main part of the base substrate can be separated in the crystal growing process.

When doping amount of hydrogen ion is too small, it becomes difficult to securely separate the thin film part from the base substrate. When doping amount of hydrogen ion is too big, the thin film part may be largely damaged and it becomes difficult to separate the thin film part which is in a form of one sheet with substantially uniform thickness from the base substrate.

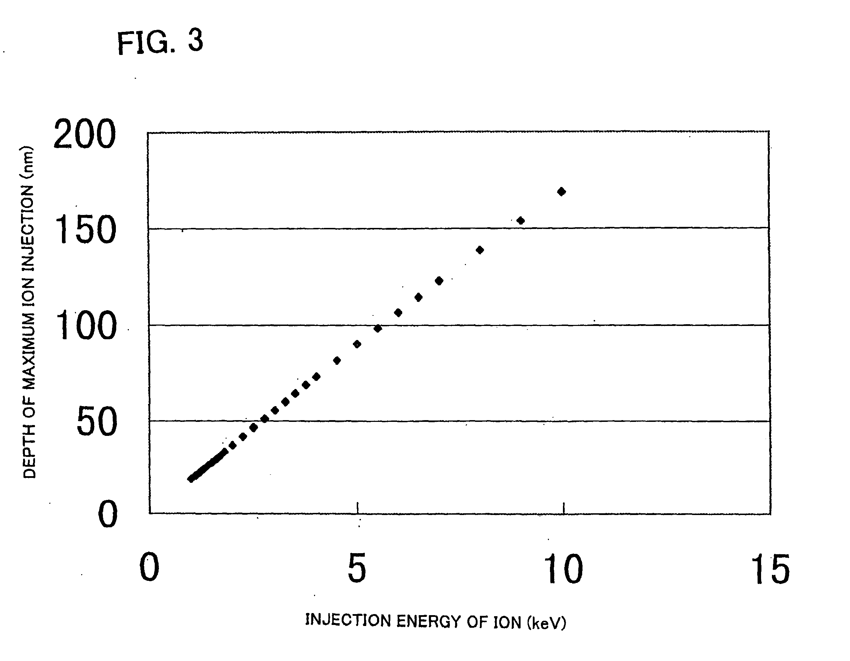

Alternatively, the thickness of the thin film part separated from the base substrate can be controlled by varying the incident energy. FIG. 3 illustrates the result of measuring depth (depth h at the maximum ion concentration) of injecting ion toward injection energy of ion. Accordingly, for example, because the depth of ion injection (depth h at the maximum ion concentration) is approximately in proportion to injection energy of ion, the thickness of the thin film part may be control properly by adjusting the amount of incident energy (accelerating voltage).

By carrying out heat treatment after ion injection process before crystal growing process, a partial ruptured part (void) is formed at the ion injection layer in advance and crystallinity of the ion injection part of the base substrate, which is damaged by ion irradiation, can be recovered. As a result, crystallinity of a semiconductor which may be formed thereon may be improved.

Thickness of the thin film part may preferably 20µm or less. The thinner the thin film part is, the more tensile stress toward the objective grown semiconductor crystal is relaxed, and that can decrease generation of dislocations or cracks in the the objective grown semiconductor crystal. More preferably, thickness of the thin film part may be 2µm or less, and further preferably, 200nm or less. In order to obtain the thin film part having such an optimum thickness, ion injection energy (accelerating voltage) may be controlled in accordance with the graph in FIG. 3 so that the depth when the numbers of injected ion becomes its peak corresponds to the desired thickness of the thin film part.

When the ion injection layer becomes too thick, it becomes difficult to control thickness of the thin film part. So thickness of the ion injection layer may be determined carefully.

Although thickness of the ion injection layer cannot be strictly defined, the full width half maximum in the characteristics of the numbers of injected ion in FIG. 2, for example, may be used as one standard. The thinner the ion injection layer is, the easier the thickness of the thin film part of the base substrate becomes to be controlled.

Accordingly, in order to control thickness of the thin film part precisely, a method for keeping the energy of ion injection (accelerating voltage) constant as much as possible may be useful.

Relatively, it is preferable that thickness of an objective semiconductor crystal which is formed by crystal growth is approximately the same or larger than that of the thin film part. By employing such condition, it becomes easier to relax stress toward the objective semiconductor crystal, to thereby control generation of dislocations and cracks in the semiconductor crystal more remarkably compared with a conventional invention. This stress relaxing effect grows larger according to that thickness of the objective semiconductor crystal grows relatively thicker. Although it depends on conditions such as thickness of the thin film part, this stress relaxing effect is almost saturated with about 50µm to 200µm of the objective grown semiconductor crystal when thickness of the thin film part is 20µm or less.

In the present invention, kinds (materials) of the base substrate and the objective semiconductor crystal have no special limitation. So the present invention, including the above-described arbitrary combination of each material of the base substrate and the semiconductor crystal, can be applied to well-known and arbitral kind of hetero epitaxial growth.

While the present invention has been described with reference to the above embodiments as the most practical and optimum ones, the present invention is not limited thereto, but may be modified as appropriate without departing from the spirit of the invention.

## Claims

1. A method for crystal growth of a semiconductor which is grown on a base substrate and is made of different semiconductor material from that of the base substrate, comprising a step of:
injecting ion into said base substrate from a crystal growth front before carrying out crystal growing process of said semiconductor.

2. A method for crystal growth of a semiconductor according to claim 1, wherein a portion or the entire portion of said base substrate is ruptured by heating or cooling said base substrate after said crystal growth process.

3. A method for crystal growth of a semiconductor according claim 1 or 2, wherein ion is injected to depth of 20µm or less from said crystal growth front.

4. A method for crystal growth of a semiconductor according to any one of claims 1 to 3, wherein hydrogen ion (H⁺) or helium ion (He⁺) is used as the ion injected to said base substrate.

5. A method for crystal growth of a semiconductor according to any one of claims 1 to 4, wherein injection amount of ion injected from said crystal growth front per unit area is 1 x 10¹⁵[/cm²] to 1 x 10²⁰ [/cm²].

6. A method for crystal growth of a semiconductor according to any one of claims 1 to 5, wherein said base substrate is made of at least one selected from the group consisting of silicon (Si), sapphire (Al₂O₃), silicon carbide (SiC), gallium arsenide (GaAs), zinc oxide (ZnO), neodymium gallium oxide (NdGaO₃), lithium gallium oxide (LiGaO₂) and magnesium aluminum oxide (MgAl₂O₄).

7. A method for crystal growth of a semiconductor according to any one of claims 1 to 6, wherein a group III nitride compound semiconductor is applied as said semiconductor material.

8. A method for crystal growth of a semiconductor according to any one of claims 1 to 7, wherein said crystal growth front of said base substrate is treated by heat treatment after ion injecting process and before crystal growing process.

9. A semiconductor light-emitting device comprising at least a semiconductor crystal which is produced by a method for crystal growth of a semiconductor according to any one of claims 1 to 8 as a crystal growth substrate.

10. A semiconductor light-emitting device produced by employing crystal growth in which a semiconductor crystal produced by a method for crystal growth of a semiconductor according to any one of claims 1 to 8 is at least used as a crystal growth substrate.
